# EUROPÄISCHE PATENTSCHRIFT

(11) **EP 1 240 529 B1**
(45) Veröffentlichungstag und Bekanntmachung des Hinweises auf die Patenterteilung: **04.08.2004**
(21) Anmeldenummer: 00993537.0
(22) Anmeldetag: 13.12.2000
(51) Int. Cl.: G01P 1/02, B81B 7/00

(54) **VERFAHREN ZUR HERSTELLUNG MIKROMECHANISCHER STRUKTUREN**
METHOD FOR PRODUCING MICROMECHANICAL STRUCTURES
PROCEDE DE FABRICATION DE STRUCTURES MICRO-MECANIQUES

(30) Priorität: 22.12.1999 DE 19962231
(43) Veröffentlichungstag der Anmeldung: 18.09.2002
(73) Patentinhaber: Infineon Technologies AG, 81669 München (DE)
(72) Erfinder: AIGNER, Robert, 81675 München (DE); MICHAELIS, Sven, 20146 Hamburg (DE); BRAUER, Michael, 26689 Apen (DE); PLÖTZ, Florian, 93047 Regensburg (DE)
(74) Vertreter: Ginzel, Christian
(86) Internationale Anmeldenummer: PCT/EP2000/012672
(87) Internationale Veröffentlichungsnummer: WO 2001/046664

(56) Entgegenhaltungen:
- EP-A- 0 828 346
- US-A- 5 668 033
- US-A- 5 923 995

## Beschreibung

Die vorliegende Erfindung betrifft ein Verfahren zur Herstellung mikromechanischer Strukturen, die auf einem Grundkörper gebildet sind und von einem Abdeckkörper vor Zerstörung geschützt sind.

Mikromechanische Strukturen werden z.B. als Beschleunigungssensoren für die Airbag-Auslösung verwendet. Die mikromechanischen Strukturen bestehen dabei aus frei tragenden Teilen, wie Membranen oder Federbalken oder ähnlichem, die sich beim Einwirken einer Beschleunigung verbiegen. Anhand der Verbiegung wird ein Wert für die Beschleunigung ermittelt.

Mikromechanische Strukturen werden z.B. an der Oberfläche eines Grundkörpers angeordnet und von einem Abdeckkörper vor Umwelteinflüssen, wie mechanischer oder auch chemischer Zerstörung geschützt.

Verfahren zur Herstellung mikromechanischer Strukturen sind z.B. in Sven Michaelis and Hans-Jörg Timme, Acceleration Threshold Switches from an Additive Electroplating MEMS Process, Eurosensors XIII, The 13^{th} European Conference on Solid State Transducers, September 12-15, 1999, The Hague, The Netherlands; in M. Wycisk, T. Tönnesen and J. Binder, S. Michaelis and H.J. Timme, Low Cost Post-CMOS Integration of Electroplated Microstructures for Inertial Sensing, und in M. Wycisk and J. Binder, S. Michaelis and H.J. Timme, New Sensor on-chip Technology for Micromechanical Acceleration Threshold Switches, angegeben.

Ein Verfahren zur Abdeckung mikromechanischer Strukturen ist z.B. in Sven Michaelis, Hans-Jörg Timme, Michael Wycisk, Josef Binder, Additive Electroplating Technology as a Post-CMOS Process for the Production of MEMS-Acceleration Threshold Switches for Transportation Applications, beschrieben. Dabei wird ein speziell präparierter Abdeckkörper mit Hohlräumen an seiner Unterseite, in denen die mikromechanischen Strukturen geschützt werden, die auf dem Grundkörper angeordnet sind, verwendet. Weiterhin sind in dem Abdeckkörper durchgehende Löcher angeordnet, in denen die Kontaktpads des Grundkörpers nach dem Zusammenfügen des Grundkörpers und des Abdeckkörpers zugänglich sind. Wären diese Löcher nicht vorhanden, so wäre die Struktur nicht kontaktierbar.

Die Löcher in dem Abdeckkörper führen dazu, daß dieser brüchig und anfällig für Risse ist. Dies führt wiederum zu geringen Ausbeuten und hohen Kosten. Darüberhinaus ist die Herstellung der Löcher ein langwieriger Ätzprozeß der über sechs Stunden in Anspruch nimmt und daher kostentreibend ist.

Ein weiteres Verfahren zum Abdecken mikromechanischer Strukturen und Freilegen der Kontaktpads besteht in der Verwendung von Sägeverfahren, bei denen große Stücke des Abdeckkörpers heraus gesägt werden und in der Sägespülung abgeschwemmt werden. Das Abschwemmen der großen Stücke birgt ein großes Risiko für die Beschädigung der Strukturen und führt außerdem zu Brüchen des Sägeblatts.

Aus der Druckschrift US 5,668,033 ist ein Verfahren zur Herstellung eines Beschleunigungssensors bekannt. Der Beschleunigungssensor umfaßt eine Source-Elektrode, eine Drain-Elektrode und eine bewegliche Gate-Elektrode. wird der Sensor einer Beschleunigung unterworfen, so bewegt sich die Gate-Elektrode, wodurch sich der Drainstrom ändert. Zum Schutz der beweglichen Gate-Elektrode ist eine Abdeckung vorgesehen. Zur Herstellung des Beschleunigungssensors wird die Abdeckung mit bereits ausgebildeten Fußbereichen über eine Haftschicht mit dem eigentlichen Wafer verbunden. Anschließend wird zum Öffnen von Hohlräumen erst der Abdeckkörper alleine und dann der Verbundkörper bestehend aus Abdeckkörper und eingentlichen Wafer entlang vorgesehener Linien in einzelne Chips zersägt.

Nachteilig bei diesem Verfahren ist, dass zusätzliche Fixierungen an dem Abdeckkörper angebracht werden müssen, um beispielsweise ein Zerspringen des Abdeckkörpers zu verhindern. Diese zusätzlichen Fixierungen führen ebenfalls zu erhöhtem Produktionsaufwand.

Es ist Aufgabe der Erfindung ein Verfahren anzugeben, durch das ein Grundkörper und ein Deckkörper an ihren Oberflächen zusammengefügt werden und auf einfache Weise zumindest ein Teil der zusammengefügten Oberfläche des Grundkörpers freigelegt wird.

Erfindungsgemäß wird die gestellte Aufgabe durch ein Verfahren zur Herstellung einer mikromechanischen Struktur mit den folgenden Schritten gelöst: Zusammenfügen eines Grundkörpers mit einem Abdeckkörper entlang einer gemeinsamen Grenzfläche zu einem Verbundkörper, wobei im Verbundkörper entlang der Grenzfläche ein Hohlraum ausgebildet wird, der Hohlraum durch Abtragen von Material im Bereich einer Oberfläche des Verbundkörpers durch Sägen des Abdeckkörpers geöffnet wird, und der Grundkörper gesägt wird, wobei des Weiteren der Verbundkörper zum Sägen des Abdeckkörpers mit einer Oberfläche des Grundkörpers auf einem Träger angeordnet wird und der Verbundkörper zum Sägen des Grundkörpers mit einer Oberfläche des Abdeckkörpers auf einem Träger angeordnet wird.

Der Vorteil des erfindungsgemäßen Verfahrens liegt in der sehr einfachen Abdeckung der mikromechanischen Struktur. Darüberhinaus lassen sich nicht nur Siliziumabdeckungen verwenden, die bei den Verfahren des Standes der Technik notwendig sind, um entlang der (111)-Orientierung des Siliziumkristalls entlang zu ätzen. Erfindungsgemäß lassen sich auch kostengünstigere Materialien wie Glasabdeckungen oder Abdeckungen aus Kunststoff verwenden.

Weiterhin ist die Zeit zur Herstellung einer Abdeckung wesentlich verkürzt, da keine durchgehenden Löcher geätzt werden müssen, was üblicherweise sechs Stunden dauern würde. Weiterhin birgt das Ätzen der Löcher den Nachteil, daß Fehler in der Lackmaske bzw. Risse in den Siliziumwafer, aus dem die Abdeckung besteht, durch die lange Ätzzeit potenziert werden. Dies führt zu einer geringen Ausbeute von Abdeckungen die gemäß dem Stand der Technik hergestellt werden.

Ein weiterer Vorteil des erfindungsgemäßen Verfahrens besteht in der Möglichkeit, eine unstrukturierte Abdeckung zu verwenden und die mikromechanischen Strukturen in Vertiefungen auf dem Grundkörper anzuordnen. Durch dieses Verfahren können die Abdeckungen sehr kostengünstig gebildet werden.

Ein weiterer Vorteil des erfindungsgemäßen Verfahrens besteht darin, daß die Abdeckungen aus einem Kunststoff gebildet werden können.

Weiterhin ermöglicht das erfindungsgemäße Verfahren, lediglich Vertiefungen in dem Abdeckkörper zu bilden, in denen die mikromechanischen Strukturen beim Zusammenfügen des Grundkörpers und des Abdeckkörpers aufgenommen werden.

Bei dem Träger handelt es sich üblicherweise um eine Folie, auf die der Grundkörper auflaminiert wird. Durch dieses Verfahren und diese Anordnung ist es möglich, lediglich den Abdeckkörper einzusägen, während der Grundkörper auf dem Träger fixiert ist.

Bei dem erfindungsgemäßen Verfahren kann der Verbundkörper mit Hilfe des Abdeckkörpers auf eine Folie laminiert werden und in dem anschließenden Sägeprozeß kann zum einen der Grundkörper allein oder aber mit einer tieferen Schnittiefe sowohl der Grundkörper als auch der Abdeckkörper durchsägt werden. Im Stand der Technik ist es üblich, Wafer auf eine Folie aufzulaminieren und mit einer Kreissäge zu zerteilen, wobei lediglich der Wafer zersägt wird und die Folie unversehrt bleibt. Dieses Verfahren kann auch für das erfindungsgemäße Verfahren angewendet werden.

In einer vorteilhaften Ausprägung des erfindungsgemäßen Verfahrens wird der Hohlraum geöffnet, in dem das Material in den Bereich einer Oberfläche des Verbundkörpers zumindest teilweise mit einer Kreissäge eingesägt wird. Dadurch ist es möglich, die heutzutage beim Zersägen von Wafern zu Einzelchips verwendeten Verfahren für das erfindungsgemäße Verfahren zu verwenden. Dies hat den Vorteil, daß kein apparativer Mehraufwand bei dem erfindungsgemäßen Verfahren notwendig ist.

In einer weiteren vorteilhaften Ausprägung des erfindungsgemäßen Verfahrens wird ein in dem Hohlraum gebildeter elektrischer Kontakt zumindest teilweise freigelegt. Durch dieses Vorgehen ist es möglich, elektrische Kontakte in einem anschließenden Bondprozeß mit einem Leadframe elektrisch zu verbinden.

In einer weiteren vorteilhaften Ausprägung des erfindungsgemäßen Verfahrens wird in dem Abdeckkörper eine Vertiefung gebildet, die nach dem Zusammenfügen des Grundkörpers und des Abdeckkörpers den Hohlraum bildet. Durch dieses Verfahren ist eine einfache Bildung des Hohlraums zur Aufnahme der mikromechanischen Struktur möglich.

In einer weiteren vorteilhaften Ausprägung des erfindungsgemäßen Verfahrens wird in dem Grundkörper eine Vertiefung gebildet, die nach dem Zusammenfügen des Grundkörpers und des Abdeckkörpers den Hohlraum bildet. Durch diese Anordnung ist es möglich, elektrische Kontakte, die in dem Hohlraum gebildet sind, durch das erfindungsgemäße Verfahren freizulegen. Besonders vorteilhaft ist dabei, daß der Abdeckkörper nicht strukturiert werden muß. Dadurch können Kosten bei der Herstellung des Abdeckkörpers eingespart werden.

Weiterhin ist es vorteilhaft, daß der Abdeckkörper mittels eutektischem Bonden, Silizium-Fusions-Bonden, anodischem Bonden, Kleben und/oder Löten mit dem Grundkörper zusammengefügt wird. Diese Techniken sind zum Beispiel in Mikromechnik, A. Heuberger, Springer-Verlag, 1991, beschrieben.

Eine weitere vorteilhafte Variante des erfindungsgemäßen Verfahrens sieht vor, daß der Abdeckkörper aus Silizium, aus Glas aus Kunststoff, aus einem Polymer oder einem Polyamid besteht.

Im Stand der Technik ist man auf die Verwendung von Silizium als Abdeckkörper beschränkt. Die Verwendung von Siliziumwafern als Abdeckkörper ist dabei relativ teuer, so daß die Kosten bei der Verwendung von Glas oder Kunststoffen reduziert werden können.

In einer weiteren vorteilhaften Ausprägung des erfindungsgemäßen Verfahrens wird der Grundkörper auf eine Folie lami-niert und der Abdeckkörper mit Sägeschnitten durchtrennt. Durch dieses Verfahren ist es möglich, die Schnittiefe der Kreissäge so zu wählen, daß lediglich der Abdeckkörper durchtrennt wird um evtl. Hohlräume aufzusägen und der Grundkörper unverändert zu lassen. Vorteilhafterweise werden die Sägeschnitte dabei so ausgeführt, daß keine losen Stücke, abgesehen von dem Sägemehl, aus dem Deckkörper herausgetrennt werden und es so vermieden wird, daß Strukturen auf dem Grundkörper bzw. das Sägeblatt zerstört werden.

In einer weiteren vorteilhaften Ausprägung des erfindungsgemäßen Verfahrens wird der Verbundkörper mit dem Abdeckkörper auf eine Folie laminiert und der Verbundkörper wird mit weiteren Sägeschnitten durchgesägt, wobei vereinzelte Chips heraus gesägt werden. Durch dieses Verfahren kann der Verbundkörper, nachdem der Abdeckkörper eingesägt wurde von der Folie abgelöst werden und nun anschließend mit dem Abdeckkörper auf die Folie laminiert werden. Durch diese Topdownanordnung (der Grundkörper befindet sich mit seiner Oberfläche, auf der die mikromechanischen Strukturen und die elektrischen Kontakte angeordnet sind der Folie zugewandt) kann der Verbundkörper zersägt werden und die "losen Stücke" verbleiben auf der Folie.

Ein weiterer Verfahrensschritt sieht nun vor, daß die Sägetiefe der Kreissäge so gewählt wird, daß der gesamte Verbundkörper bestehend aus Grundkörper und Abdeckkörper in einem Sägeschnitt durchtrennt wird, so daß vereinzelte Chips, die weiterhin auf der Folie kleben bleiben, heraus gesägt werden.

In einer weiteren vorteilhaften Ausprägung des erfindungsgemäßen Verfahrens wird ein vereinzelter Chip mit einer Vakuumpipette von der Folie gelöst und die Teile des Abdeckkörpers, die oberhalb des elektrischen Kontakts angeordnet waren, verbleiben auf der Folie. Durch dieses Verfahren ist es möglich, die vereinzelten Chips von der Folie abzulösen, wobei die Abdeckungen, die ursprünglich über den elektrischen Kontakten angeordnet waren, weiterhin auf der Folie kleben bleiben.

In einer weiteren vorteilhaften Ausprägung des erfindungsgemäßen Verfahrens weist ein Chip nach dem Zersägen des Verbundkörpers elektrische Kontakte an mindestens einer Seite auf. Chips weisen üblicherweise eine rechteckige Form auf, wobei in dieser Variante eine Seite des Chips mit elektrischen Kontakten versehen ist.

In einer weiteren vorteilhaften Ausprägung des erfindungsgemäßen Verfahrens weist der Chip nach dem Zersägen des Verbundkörpers elektrische Kontakte an einer Seite und an mindestens einer benachbarten Seite auf. Durch diese Anordnung ist es möglich, die Anzahl der elektrischen Kontakte zu erhöhen und auf zwei benachbarte Seiten eines Chips zu verteilen.

In einer weiteren vorteilhaften Ausprägung des erfindungsgemäßen Verfahrens weist der Chip nach dem Zersägen des Verbundkörpers elektrische Kontakte an einer Seite und an einer gegenüber liegenden Seite auf. Durch diese Anordnung der elektrischen Kontakte ist es möglich, ihre Anzahl zu erhöhen. Dadurch werden kleinere Chips ermöglicht, die eine größere Anzahl von Kontakten aufweisen. Ebenfalls ist die integration von mehr Funktionalität auf dem Chip ermöglicht, wie z.B. die integration eines Mikrokontrollers, wodurch sich die Produktvielfalt erhöht.

In einer weiteren vorteilhaften Ausprägung des erfindungsgemäßen Verfahrens weist der Chip nach dem Zersägen des Verbundkörpers an mindestens drei benachbarten Seiten elektrische Kontakte auf. Dadurch ist es möglich, die Anzahl der elektrischen Kontakte noch weiter zu erhöhen.

Weitere vorteilhafte Ausgestaltung der Erfindung sind in den abhängigen Ansprüchen angegeben.

Ausführungsbeispiele der Erfindung werden nachfolgend anhand der Zeichnungen dargestellt und erläutert.

In den Figuren zeigen:
- Figur 1:: ein Ausführungsbeispiel einer erfindungsgemäßen mikromechanischen Struktur;
- Figur 2: das Ausführungsbeispiel einer mikromechanischen Struktur gemäß Figur 1 zu einem späteren Prozeßzeitpunkt;
- Figur 3: das Ausführungsbeispiel gemäß Figur 1, wobei der Verbundkörper in Einzelchips zersägt ist;
- Figur 4: eine weitere erfindungsgemäße mikromechanische Struktur;
- Figur 5: die erfindungsgemäße mikromechanische Struktur aus Figur 4 zu einem späteren Prozeßzeitpunkt;
- Figur 6: die erfindungsgemäße mikromechanische Struktur aus Figur 5, wobei der Verbundkörper in Einzelchips separiert ist;
- Figur 7a: ein Querschnitt durch eine erfindungsgemäße mikromechanische Struktur;
- Figur 7b: Die Draufsicht auf die erfindungsgemäße mikromechanische Struktur aus Figur 7a, zur Ausbildung eines Chips mit elektrischen Kontakten an einer Seite des Chips;
- Figur 8a: Ein Querschnitt durch eine weitere erfindungsgemäße mikromechanische Struktur;
- Figur 8b: die Draufsicht auf die in Figur 8a dargestellte mikromechanische Struktur, wobei elektrische Kontakte so angeordnet sind, daß bei dem Zertrennen des Verbundkörpers einzelne Chips entstehen, die elektrische Kontakte auf zwei gegenüber liegenden Seiten aufweisen;
- Figur 9a: ein Querschnitt durch eine weitere mikromechanische Struktur;
- Figur 9b: die Draufsicht auf die in Figur 9a dargestellte mikromechanische Struktur, wobei die elektrischen Kontakte so angeordnet sind, daß die Chips nach dem Zertrennen elektrische Kontakte an zwei benachbarten Seiten aufweisen;
- Figur 10a: eine weitere erfindungsgemäße mikromechanische Struktur im Querschnitt;
- Figur 10b: die Draufsicht auf die in Figur 10a dargestellte mikromechanische Struktur, wobei elektrische Kontakte so angeordnet sind, daß jeder Chip nach dem Zertrennen an drei benachbarten Seiten elektrische Kontakte aufweist.

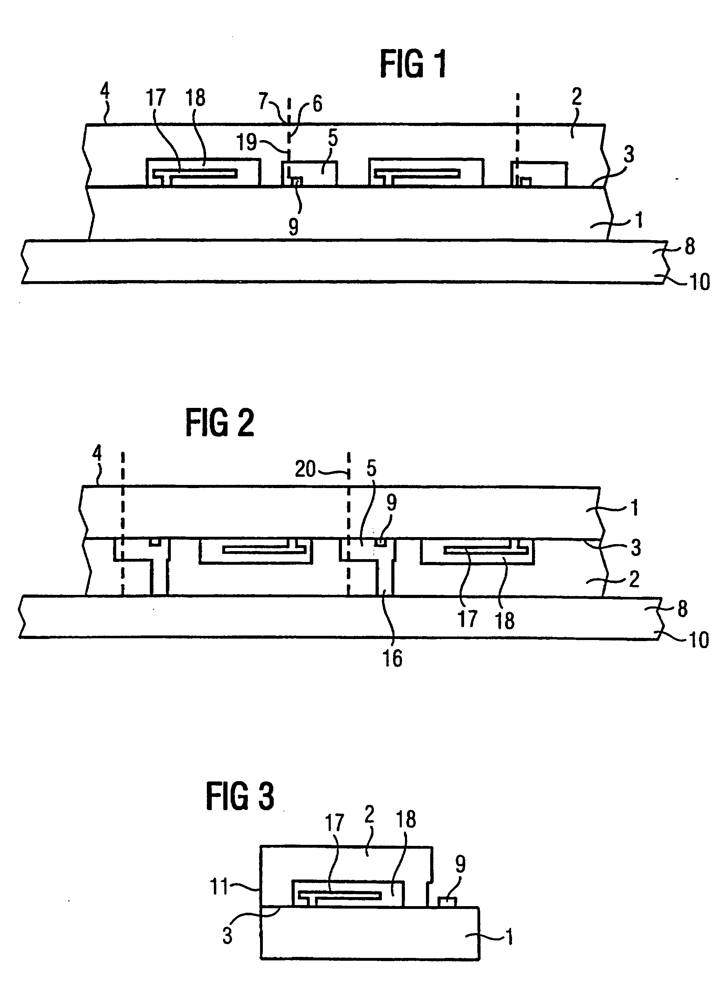

In Figur 1 ist eine erfindungsgemäße mikromechanische Struktur dargestellt, die aus einem Grundkörper 1 besteht, und mit dem Abdeckkörper 2 an einer gemeinsamen Grenzfläche 3 verbunden ist. Auf dem Grundkörper 1 ist dabei eine mikromechanische Struktur 17 und ein elektrischer Kontakt 9 angeordnet. Der Grundkörper 1 ist seinerseits auf einem Träger 8 montiert, der in diesem Fall aus einer Folie 10 besteht. In diesem Fall ist also der Verbundkörper 4, der aus dem Grundkörper 1 und dem Abdeckkörper 2 besteht, auf die Folie 10 auflaminiert. In dem Verbundkörper 4 ist ein Hohlraum 5 angeordnet, in dem sich der elektrische Kontakt 9 befindet. Weiterhin ist ein Hohlraum 18 in dem Verbundkörper entlang der gemeinsamen Grenzfläche 3 angeordnet, in dem sich die mikromechanische Struktur 17 befindet. Nun wird der Abdeckkörper entlang der gestrichelten Linie 19 mit einer Kreissäge angesägt. Dabei bleibt der elektrische Kontakt 9 und der Grundkörper 1 größtenteils unversehrt.

Anschließend wird der Verbundkörper 4 von dem Träger 8 abgelöst und mit Bezug auf Figur 2 mit dem Abdeckkörper auf den Träger 8 montiert, indem der Abdeckkörper 2 auf die Folie 10 auflaminiert wird.

Deutlich ist in Figur 2 die Öffnung 16 zu erkennen, die durch die Ansägung 19 des Abdeckkörpers 2 entstanden ist. Mit einem weiteren Sägeschritt 20 wird der Verbundkörper durchtrennt. Dabei verläuft die Sägung so, daß der Hohlraum 5 zumindest teilweise durchsägt wird, so daß der in Figur 3 dargestellte vereinzelte Chip 11 entsteht.

Die erste Sägung 19 wird so durchgeführt, daß keine Bruchstücke aus dem Abdeckkörper 2 herausgetrennt werden, die das Sägeblatt zerstören könnten. Die Durchsägung 20 wird so durchgeführt, daß die Schnittiefe ausreicht, den Verbundkörper als Gesamtes zu durchtrennen, jedoch der Träger 8 seine Funktion als Trägermaterial beibehält, und nicht durchtrennt wird.

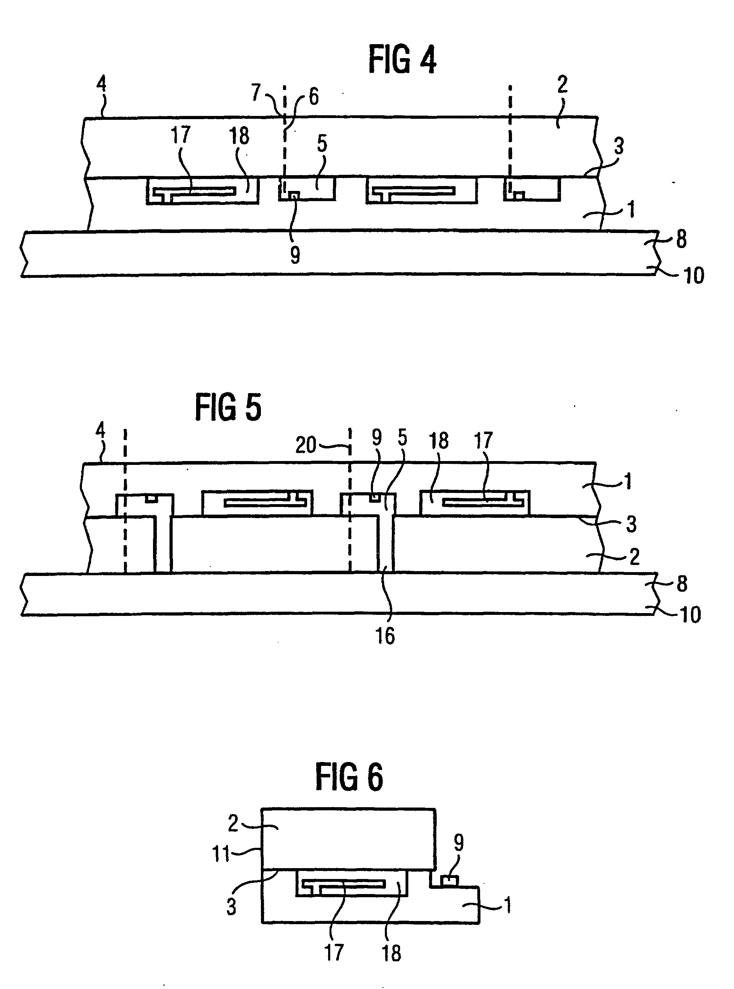

Mit Bezug auf Figur 4 ist ein weiteres Ausführungsbeispiel der Erfindung gezeigt. Der Unterschied zu Figur 1 besteht darin, daß der Abdeckkörper 2 größtenteils unstrukturiert ist und der Hohlraum 5 mit dem in ihm befindlichen elektrischen Kontakt 9 als auch der weitere Hohlraum 18 mit der in ihm befindlichen mikromechanischen Struktur 17 in dem Grundkörper 1 ausgebildet sind. Der Vorteil der in Figur 4 dargestellten Variante der Erfindung besteht in der Verwendbarkeit eines unstrukturierten Abdeckkörpers 2. Auch hier wird der Abdeckkörper 2 an einer nach außen weisenden Oberfläche 7 eingesägt, so daß das Material 6 entfernt wird.

Anschließend wird der Verbundkörper 4 von dem Trägermaterial 8 gelöst und mit Bezug auf Figur 5 mit dem Abdeckkörper 2 auf das Trägermaterial, das in diesem Fall aus einer Folie besteht, auflaminiert. Mit Bezug auf Figur 5 wird der Verbundkörper 4 entlang der gestrichelten Linie 20 durchgesägt, wobei ein vereinzelter Chip 11 entsteht.

In Figur 6 ist ein vereinzelter Chip bestehend aus einem Grundkörper 1, einem Abdeckkörper 2, die an einer gemeinsamen Grenzfläche 3 verbunden sind, dargestellt. Weiterhin befindet sich in dem Hohlraum 18, der zwischen dem Grundkörper 1 und dem Abdeckkörper 2 angeordnet ist, eine mikromechanische Struktur 17.

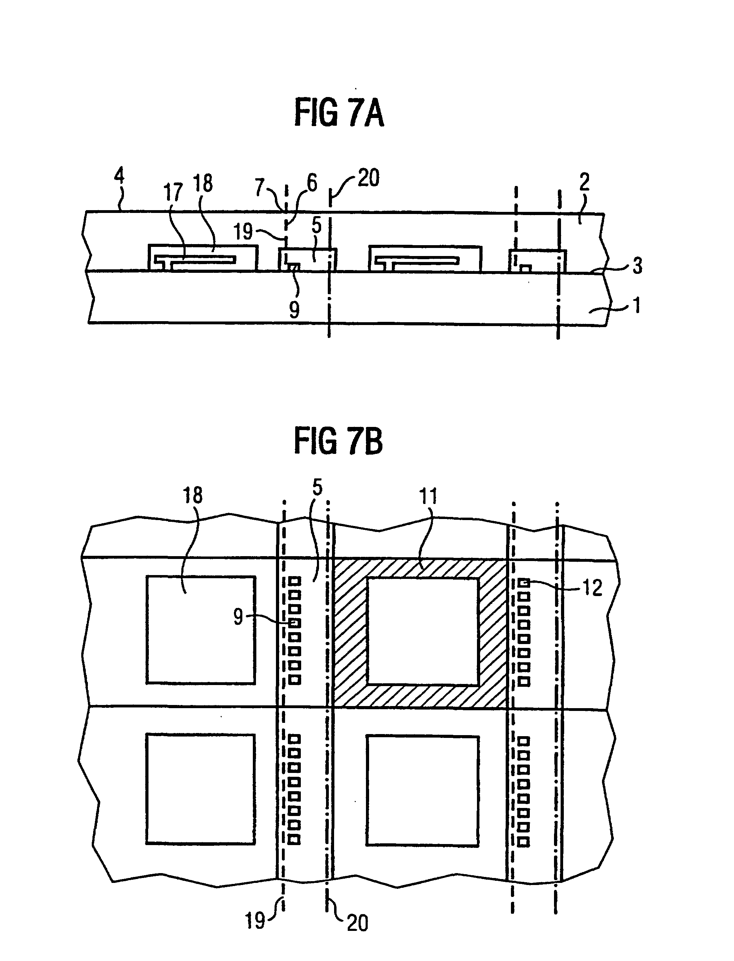

Mit Bezug auf Figur 7a und Figur 7b wird ein Sägeverfahren beschrieben, mit dem aus einem Verbundkörper 4 vereinzelte Chips 11 heraus gesägt werden können, die elektrische Kontakte an einer Seite aufweisen. In Figur 7b ist die Draufsicht auf einen Verbundkörper 4 dargestellt. Schraffiert unterlegt ist der später entstehende vereinzelte Chip 11. In dem Verbundkörper befindet sich ein Hohlraum 5, der mit einer Ansägung 19 des Abdeckkörpers 2 geöffnet wird. Mit der Durchsägung 20 wird der Verbundkörper in Einzelchips 11 zerlegt. Nach dem Zerlegen in Einzelchips befinden sich elektrische Kontakte 12 an einer Seite des Chips 11.

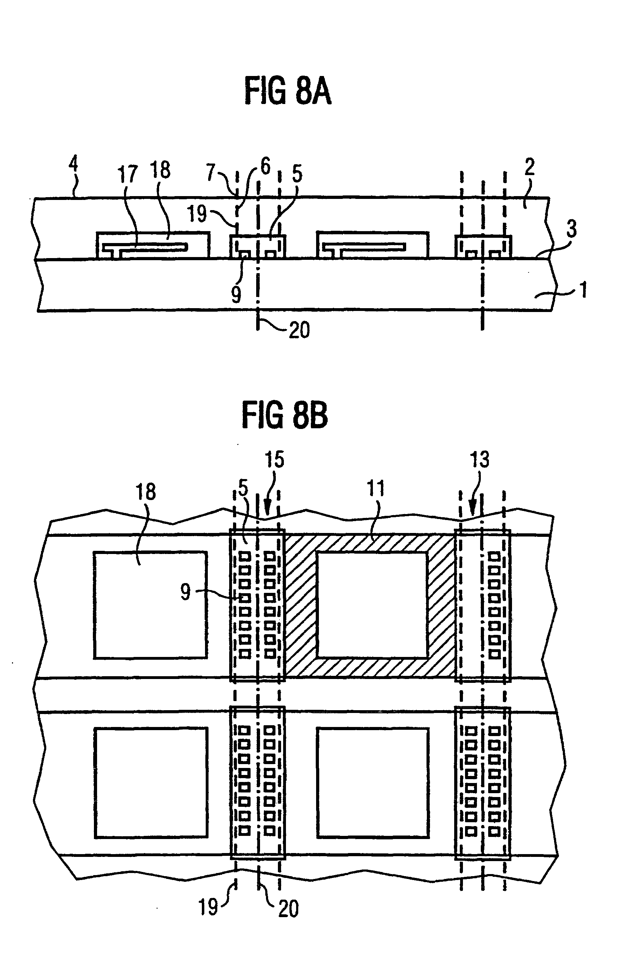

Mit Bezug auf Figur 8a und Figur 8b wird ein Sägeverfahren zur Herstellung von Einzelchips beschrieben, bei denen elektrische Kontakte auf einer Seite 13 und auf einer gegenüber liegenden Seite 15 angeordnet sind.

Mit Bezug auf Figur 8b sind zwei Reihen von elektrischen Kontakten 9 in dem Hohlraum 5 angeordnet. Mit einer Ansägung 19 des Abdeckkörpers 2 wird der Hohlraum 5 geöffnet. Anschließend wird der Verbundkörper mit dem Abdeckkörper auf eine Folie 10 laminiert und der Verbundkörper mit der Durchsägung 20 in vereinzelte Chips zerteilt.

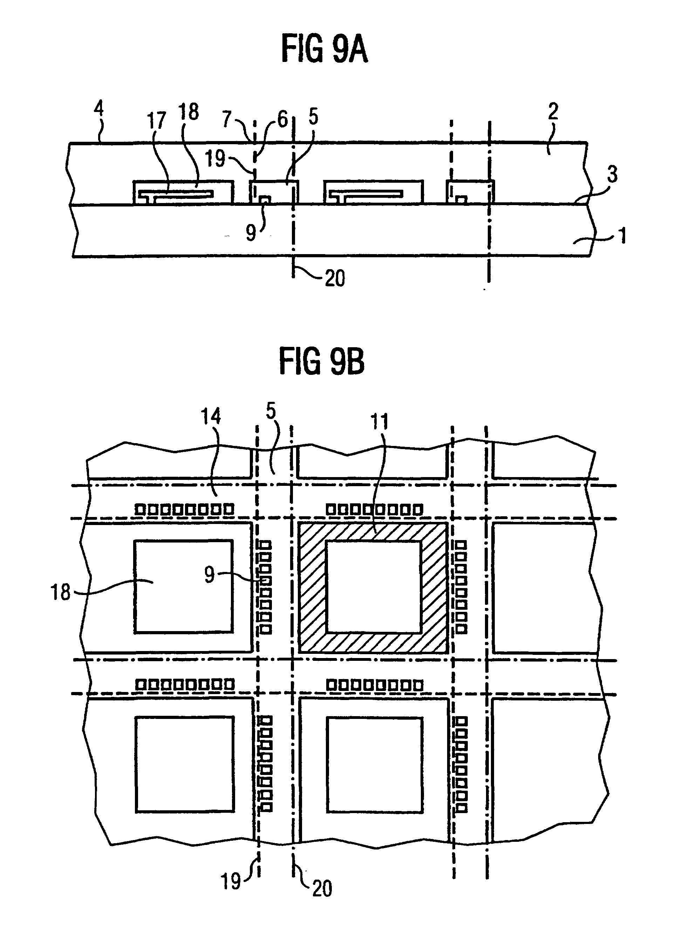

Mit Bezug auf Figur 9a und Figur 9b ist ein weiteres Ausführungsbeispiel für die Sägung eines Verbundkörpers dargestellt.

Mit Bezug auf Figur 9b sind elektrische Kontakte 9 an zwei Seiten des Chips angeordnet. Zunächst wird der Hohlraum 5 mit der Ansägung 19 geöffnet, anschließend wird der Abdeckkörper 2 auf die Folie 10 laminiert und der Verbundkörper 4, bestehend aus Grundkörper und Abdeckkörper, wird als Ganzes zersägt. Bei der Zersägung entstehen vereinzelte Chips 11, die elektrische Kontakte an zwei benachbarten Seiten aufweisen.

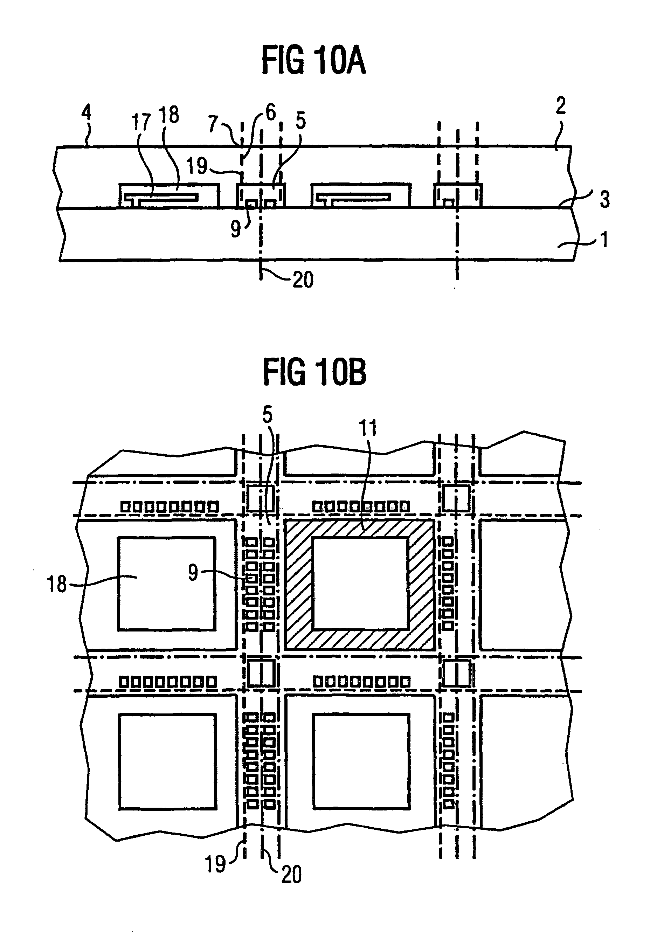

Mit Bezug auf Figur 10a und Figur 10b wird ein Herstellungsverfahren für vereinzelte Chips beschrieben, die elektrische Kontakte an drei benachbarten Seiten aufweisen.

Auf einem Grundkörper 1 werden zwei Reihen von elektrischen Kontakten 9 angeordnet. Anschließend wird ein Abdeckkörper 2 mit dem Grundkörper 1 verbunden, so daß die elektrischen Kontakte 9 in den Hohlraum 5 angeordnet sind. Mit einer Ansägung 19 des Abdeckkörpers 2 wird der Hohlraum 5 geöffnet. Anschließend wird der Verbundkörper mit dem Abdeckkörper auf eine Folie 10 laminiert. Mit der Durchsägung 20 wird der Verbundkörper 4 in vereinzelte Chips 11 zersägt.

Durch das in dem oben beschriebenen Verfahren verwendete zweiseitige Sägen des Verbundkörpers 4 mit verschiedenen Sägetiefen, können die elektrischen Kontakte frei gelegt werden, ohne daß sich Stücke des Abdeckwafers lösen und in der Sägespülung abgeschwemmt werden. Die elektrischen Kontakte sind dabei in Hohlräumen angeordnet, die in einem ersten Sägeschritt geöffnet werden, indem der Abdeckkörper 2 eingesägt wird. Bei diesem ersten Sägeprozeß ist der Verbundkörper 4 mit dem Grundkörper 1 auf die Folie 10 laminiert. Die Sägetiefe ist dabei so zu wählen, daß nur der Abdeckkörper durchtrennt wird und die Strukturen auf dem Grundkörper erhalten bleiben. Die Sägelinien sind dabei so angeordnet, daß bestimmte Teile des Hohlraums 5 tangiert werden, aber keine "losen Teile" aus dem Abdeckkörper 2 heraus gesägt werden. Das bedeutet, daß Stützen erhalten bleiben an denen die angesägten Teile des Abdeckkörpers zunächst befestigt bleiben.

Nach dem ersten Sägeschritt wird der Verbundkörper von der Folie entfernt und mit dem Abdeckkörper erneut auf die Folie laminiert. In einem zweiten Sägeschritt wird der Verbundkörper, der aus dem Grundkörper und dem Abdeckkörper besteht, vollständig durchtrennt. Nach dem zweiten Sägeschritt sind vereinzelte Chips entstanden, die auf der Folie kleben. Diese können nun mit Standardverfahren von der Sägefolie gelöst werden. Die Teile des Abdeckkörpers, die über den elektrischen Kontakten lagen, bleiben auf der Sägefolie kleben.

## Patentansprüche

1. Verfahren zur Herstellung einer mikromechanischen Struktur mit folgenden Verfahrensschritten:
- Zusammenfügen eines Grundkörpers (1) mit einem Abdeckkörper (2) entlang einer gemeinsamen Grenzfläche (3) zu einem Verbundkörper (4), wobei im Verbundkörper (4) entlang der Grenzfläche (3) ein Hohlraum (5) ausgebildet wird,
- der Hohlraum (5) durch Abtragen von Material (6) im Bereich einer Oberfläche (7) des verbundkörpers (4) durch Sägen des Abdeckkörpers (2) geöffnet wird,
- Sägen des Grundkörpers (1),
**dadurch gekennzeichnet, daß**
der Verbundkörper (4) zum Sägen des Abdeckkörpers (2) mit einer Oberfläche des Grundkörpers (1) auf einem Träger (8) angeordnet wird, und
der Verbundkörper (4) zum Sägen des Grundkörpers (1) mit einer Oberfläche des Abdeckkörpers (2) auf einem Träger (8) angeordnet wird.

2. Verfahren nach Anspruch 1
**dadurch gekennzeichnet, daß**
der Hohlraum (5) geöffnet wird, indem das Material (6) in dem Bereich einer Oberfläche (7) des Verbundkörpers (4) zumindest teilweise mit einer Kreissäge eingesägt wird.

3. Verfahren nach einem der Ansprüche 1 oder 2
**dadurch gekennzeichnet, daß**
ein in dem Hohlraum (5) gebildeter elektrischer Kontakt (9) zumindest teilweise freigelegt wird.

4. Verfahren nach einem der Ansprüche 1 bis 3
**dadurch gekennzeichnet, daß**
in dem Abdeckkörper (2) eine Vertiefung gebildet wird, die nach dem Zusammenfügen des Grundkörpers (1) und des Abdeckkörpers (2) den Hohlraum (5) bildet.

5. Verfahren nach einem der Ansprüche 1 bis 4
**dadurch gekennzeichnet, daß**
in dem Grundkörper (1) eine Vertiefung gebildet wird, die nach dem Zusammenfügen des Grundkörpers (1) und des Abdeckkörpers (2) den Hohlraum (5) bildet.

6. Verfahren nach einem der Ansprüche 1 bis 5
**dadurch gekennzeichnet, daß**
es sich bei dem Grundkörper (1) um Silizium, Galliumarsenid, Keramik oder Glas handelt.

7. Verfahren nach einem der Ansprüche 1 bis 6
**dadurch gekennzeichnet, daß**
der Abdeckkörper (2) mittels eutektischem Bonden, Silizium-Fusions-Bonden, anodischem Bonden, Kleben und/oder Löten mit dem Grundkörper (1) zusammengefügt wird.

8. Verfahren nach einem der Ansprüche 1 bis 7
**dadurch gekennzeichnet, daß**
der Abdeckkörper (2) aus Silizium, Glas oder Kunststoff besteht.

9. Verfahren nach einem der Ansprüche 1 bis 8
**dadurch gekennzeichnet, daß**
der Grundkörper (1) auf eine Folie (10) laminiert wird und der Abdeckkörper (2) mit Sägeschnitten durchtrennt wird.

10. Verfahren nach einem der Ansprüche 1 bis 9
**dadurch gekennzeichnet, daß**
der Verbundkörper (4) mit dem Abdeckkörper (2) auf eine Folie laminiert wird und weitere Sägeschnitte den Verbundkörper (4) durchsägen, wobei ein vereinzelter Chip (11) herausgesägt wird.

11. Verfahren nach Anspruch 10
**dadurch gekennzeichnet, daß**
der vereinzelte Chip (11) mit einer Vakuumpipette von der Folie gelöst wird und die Teile des Abdeckkörpers (2), die oberhalb des elektrischen Kontakts (9) angeordnet waren, auf der Folie verbleiben.

12. Verfahren nach einem der Ansprüche 1 bis 11
**dadurch gekennzeichnet, daß**
nach dem Zersägen des Verbundkörpers (4) ein Chip (11) elektrische Kontakte (12) an mindestens einer Seite (13) aufweist.

13. Verfahren nach einem der Ansprüche 1 bis 12
**dadurch gekennzeichnet, daß**
nach dem Zersägen des Verbundkörpers (4) der Chip (11) elektrische Kontakte (12) an der Seite (13) und mindestens einer benachbarten Seite (14) aufweist.

14. Verfahren nach einem der Ansprüche 1 bis 13
**dadurch gekennzeichnet, daß**
nach dem Zersägen des Verbundkörpers (4) der Chip (11) elektrische Kontakte (12) an der Seite (13) und einer gegenüberliegenden Seite (15) aufweist.

## Claims

1. Method of producing a micromechanical structure with the following method steps:
- joining a base body (1) together with a covering body (2) along a common boundary surface (3) to form a composite body (4), with a cavity (5) being formed in the composite body (4) along the boundary surface (3),
- opening the cavity (5) by removing material (6) in the region of one surface (7) of the composite body (4) by sawing the covering body (2),
- sawing the base body (1),
**characterized in that**
the composite body (4) is arranged with a surface of the base body (1) on a support (8) for the sawing of the covering body (2), and
the composite body (4) is arranged with a surface of the covering body (2) on a support (8) for the sawing of the base body (1).

2. Method according to Claim 1, **characterized in that** the cavity (5) is opened by the material (6) in the region of one surface (7) of the composite body (4) being sawn into at least partially with a circular saw.

3. Method according to either of Claims 1 and 2, **characterized in that** an electrical contact (9) formed in the cavity (5) is at least partially exposed.

4. Method according to one of Claims 1 to 3, **characterized in that** a depression which forms the cavity (5) after the base body (1) and the covering body (2) have been joined together is formed in the covering body (2).

5. Method according to one of Claims 1 to 4, **characterized in that** a depression which forms the cavity (5) after the base body (1) and the covering body (2) have been joined together is formed in the base body (1).

6. Method according to one of Claims 1 to 5, **characterized in that** the base body (1) is of silicon, gallium arsenide, ceramic or glass.

7. Method according to one of Claims 1 to 6, **characterized in that** the covering body (2) is joined together with the base body (1) by means of eutectic bonding, silicon-fusion bonding, anodic bonding, adhesive bonding and/or soldering.

8. Method according to one of Claims 1 to 7, **characterized in that** the covering body (2) consists of silicon, glass or plastic.

9. Method according to one of Claims 1 to 8, **characterized in that** the base body (1) is laminated onto a film (10) and the covering body (2) is severed by sawing cuts.

10. Method according to one of Claims 1 to 9, **characterized in that** the composite body (4) is laminated with the covering body (2) onto a film and further sawing cuts saw through the composite body (4), with an individually separated chip (11) being sawn out.

11. Method according to Claim 10, **characterized in that** the individually separated chip (11) is detached from the film by a vacuum pipette and the parts of the covering body (2) that were arranged above the electrical contact (9) remain on the film.

12. Method according to one of Claims 1 to 11, **characterized in that**, after the sawing-up of the composite body (4), a chip (11) has electrical contacts (12) on at least one side (13).

13. Method according to one of Claims 1 to 12, **characterized in that**, after the sawing-up of the composite body (4), the chip (11) has electrical contacts (12) on the side (13) and at least one adjacent side (14).

14. Method according to one of Claims 1 to 13, **characterized in that**, after the sawing-up of the composite body (4), the chip (11) has electrical contacts (12) on the side (13) and a side (15) lying opposite.

## Revendications

1. Procédé de fabrication d'une structure micro-mécanique, comprenant les stades de procédé suivant :
- assemblage d'une embase (1) à une pièce (2) de finition le long d'une surface (3) limite commune en une pièce (4) composite, avec formation dans la pièce (4) composite d'une cavité (5) le long de la surface (3) limite,
- la cavité (5) étant ouverte par enlèvement de matière (6) dans la zone d'une surface (7) de la pièce (4) composite par sciage de la pièce (2) de finition,
- sciage de l'embase (1),
**caractérisé en ce que**
- on met la pièce (4) composite, pour le sciage de la pièce (2) de finition, en ayant une surface de l'embase (1) sur un support (8),
- on met la pièce (4) composite, pour le sciage de l'embase (1 ), en ayant une surface de la pièce (2) de finition sur un support (8).

2. Procédé de fabrication d'une structure micro-mécanique suivant la revendication 1,
**caractérisé en ce que**
- on ouvre la cavité (5) en sciant la matière (6) dans la zone d'une surface (7) de la pièce (4) composite au moins en partie à l'aide d'une scie circulaire.

3. Procédé de fabrication d'une structure micro-mécanique suivant l'une des revendications 1 ou 2,
**caractérisé en ce que**
- l'on dénude, au moins en partie, un contact (9) électrique formé dans la cavité (5).

4. Procédé de fabrication d'une structure micro-mécanique suivant l'une des revendications 1 à 3,
**caractérisé en ce que**
- on forme dans la pièce (2) de finition un évidement qui forme, après l'assemblage de l'embase (1) et de la pièce (2) de finition, la cavité (5).

5. Procédé de fabrication d'une structure micro-mécanique suivant l'une des revendications 1 à 4,
**caractérisé en ce que**
- l'on forme dans l'embase (1) un évidement qui forme, après l'assemblage de l'embase (1) et de la pièce (2) de finition, la cavité (5).

6. Procédé de fabrication d'une structure micro-mécanique suivant l'une des revendications 1 à 5,
**caractérisé en ce que**
- l'embase (1) est en silicium, en arséniure de gallium, en céramique ou en verre.

7. Procédé de fabrication d'une structure micro-mécanique suivant l'une des revendications 1 à 6,
**caractérisé en ce que**
- la pièce (2) de finition est assemblée à l'embase (1) au moyen d'une liaison eutectique, d'une liaison par fusion du silicium, d'une liaison anodique, d'un collage / ou d'un brasage.

8. Procédé de fabrication d'une structure micro-mécanique suivant l'une des revendications 1 à 7,
**caractérisé en ce que**
- la pièce (2) de finition est en silicium, en verre ou en matière plastique.

9. Procédé de fabrication d'une structure micro-mécanique suivant l'une des revendications 1 à 8,
**caractérisé en ce que**
- l'on lamine l'embase (1) sur un ruban (10) et on sépare la pièce (2) de finition par des traits de scie.

10. Procédé de fabrication d'une structure micro-mécanique suivant l'une des revendications 1 à 9,
**caractérisé en ce que**
- on lamine la pièce (4) composite avec la pièce (2) de finition sur un ruban et on scie par d'autres traits de scie la pièce (4) composite en enlevant par sciage une puce (11 ) individualisée.

11. Procédé de fabrication d'une structure micro-mécanique suivant la revendication 10,
**caractérisé en ce que**
- l'on détache la puce (11) individualisée du ruban à l'aide d'une pipette d'aspiration et on laisse sur le ruban les parties de la pièce (2) de finition, qui sont au-dessus du contact (9) électrique.

12. Procédé de fabrication d'une structure micro-mécanique suivant l'une des revendications 1 à 11,
**caractérisé en ce que**
- après la destruction par sciage de la pièce (4) composite, une puce (11) a des contacts (12) électrique, sur au moins un côté.

13. Procédé de fabrication d'une structure micro-mécanique suivant l'une des revendications 1 à 13,
**caractérisé en ce que**
- après la destruction par sciage de la pièce (4) composite, la puce a des contacts (12) électrique sur le côté (13) et au moins sur un côté (14) voisin.

14. Procédé de fabrication d'une structure micro-mécanique suivant l'une des revendications 1 à 13,
**caractérisé en ce que**
- après la destruction par sciage de la pièce (4) composite, la puce a des contacts (12) électrique sur le côté (13) et sur un côté (15) opposé.
